# EUROPÄISCHE PATENTSCHRIFT

(11) **EP 2 248 191 B1**
(45) Veröffentlichungstag und Bekanntmachung des Hinweises auf die Patenterteilung: **15.08.2018**
(21) Anmeldenummer: 09714695.5
(22) Anmeldetag: 11.02.2009
(51) Int. Cl.: H01L 33/40, H01L 33/42

(54) **HALBLEITERLEUCHTDIODE UND VERFAHREN ZUR HERSTELLUNG EINER HALBLEITERLEUCHTDIODE**
SEMICONDUCTOR LIGHT-EMITTING DIODE AND METHOD FOR PRODUCING A SEMICONDUCTOR LIGHT-EMITTING DIODE
DIODE ÉLECTROLUMINESCENTE À SEMI-CONDUCTEUR ET PROCÉDÉ DE FABRICATION D'UNE DIODE À SEMI-CONDUCTEUR

(30) Priorität: 29.02.2008 DE 102008011847; 06.06.2008 DE 102008027045
(43) Veröffentlichungstag der Anmeldung: 10.11.2010
(73) Patentinhaber: OSRAM Opto Semiconductors GmbH, 93055 Regensburg (DE)
(72) Erfinder: AHLSTEDT, Magnus, 93049 Regensburg (DE); BAUR, Johannes, 93051 Regensburg (DE); ZEHNDER, Ulrich, 93191 Rettenbach (DE); STRASSBURG, Martin, 93105 Tegernheim (DE); SABATHIL, Matthias, 93059 Regensburg (DE); HAHN, Berthold, 93155 Hemau (DE)
(74) Vertreter: Epping - Hermann - Fischer
(86) Internationale Anmeldenummer: PCT/DE2009/000192
(87) Internationale Veröffentlichungsnummer: WO 2009/106038

(56) Entgegenhaltungen:
- WO-A-01/86731
- WO-A-2007/105626
- WO-A-2009/015645
- WO-A2-2009/083001
- DE-A1-102004 050 891
- DE-A1-102005 013 894
- DE-A1-102006 023 685
- JP-A- 2004 146 541
- US-A1- 2003 166 308
- US-A1- 2004 135 166
- US-A1- 2005 121 685
- US-A1- 2006 249 736
- US-A1- 2007 020 788
- BETZ ET AL: "On the synthesis of ultra smooth ITO thin films by conventional direct current magnetron sputtering" THIN SOLID FILMS, ELSEVIER-SEQUOIA S.A. LAUSANNE, CH, Bd. 516, Nr. 7, 29. Januar 2008 (2008-01-29), Seiten 1334-1340, XP022436931 ISSN: 0040-6090

## Beschreibung

Die Erfindung betrifft eine Halbleiterleuchtdiode und ein Verfahren zum Herstellen einer Halbleiterleuchtdiode.

Halbleiterleuchtdioden besitzen einen Schichtenstapel aus Halbleiterschichten, deren Materialien (hinsichtlich Grundmaterial und Dotierstoff) gezielt ausgewählt und aufeinander abgestimmt sind, um die optoelektronischen Eigenschaften und die elektronische Bandstruktur innerhalb der einzelnen Schichten und an den Schichtgrenzen in vorbestimmtem Ausmaß einzustellen. Am Übergang zwischen zwei benachbarten, zueinander komplementär dotierten Leuchtdiodenschichten (p- und n-dotiert) entsteht eine optisch aktive Zone, die beim Stromfluss durch den Halbleiterschichtenstapel elektromagnetische Strahlung emittiert. Die erzeugte Strahlung wird zunächst in alle Richtungen, d.h. nur teilweise in Abstrahlungsrichtung der Halbleiterleuchtdiode emittiert. Um denjenigen Anteil der Strahlung, der zur entgegengesetzten Seite des Halbleiterschichtenstapels emittiert wird, wieder zurück in Abstrahlungsrichtung zu reflektieren, sind hinter dem Halbleiterschichtenstapel eine Oxidschicht aus einem transparenten leitfähigen Oxid und eine oder mehrere Spiegelschichten vorgesehen. Die auf die Spiegelschichten auftreffende elektromagnetische Strahlung wird zu einem Anteil reflektiert, der von der Differenz der optischen Brechungsindizes der Schichten, von der Leitfähigkeit der Spiegelschicht, von der Transparenz der Oxidschicht sowie von der Dicke der Oxidschicht und der ihr vorgelagerten Schichten zur optisch aktischen Zone hin abhängt. Zur Steigerung des reflektierten Anteils werden herkömmlich neben den Schichtdicken vor allem die Materialeigenschaften und Materialzusammensetzungen der jeweiligen Schichten verändert und optimiert.

Die Druckschriften WO 2007/105626 A, JP 2004 146541 A und US 2004/135166 A1 beschreiben jeweils eine Halbleiterleuchtdiode gemäß dem Oberbegriff des Anspruchs 1.

Die Druckschriften DE 10 2006 023685 A1, WO 01/86731 A und US 2003/166308 A1 beschreiben TCO-Schichten mit einer Rauhigkeit von weniger als 1 nm.

Wenn sich der Anteil der auf die Spiegelschicht auftreffenden elektromagnetischen Strahlung, der durch die Spiegelschicht wieder zurück reflektiert wird, vergrößern ließe, könnte die Lichtausbeute von Halbleiterleuchtdioden erhöht werden.

Dies wird durch eine Halbleiterleuchtdiode gemäß Anspruch 1 sowie durch ein Verfahren gemäß Anspruch 12 ermöglicht. Die Ansprüche 1 und 12 definieren die vorliegende Erfindung. Es wird eine Halbleiterleuchtdiode mit zumindest einer p-dotierten Leuchtdiodenschicht, einer n-dotierten Leuchtdiodenschicht und einer optisch aktiven Zone zwischen der p-dotierten Leuchtdiodenschicht und der n-dotierten Leuchtdiodenschicht, mit einer Oxidschicht aus einem transparenten leitfähigen Oxid und mit mindestens einer Spiegelschicht bereitgestellt, wobei die Oxidschicht zwischen den Leuchtdiodenschichten und der mindestens einen Spiegelschicht angeordnet ist und eine erste Grenzfläche, die den Leuchtdiodenschichten zugewandt ist, und eine zweite Grenzfläche, die der mindestens einen Spiegelschicht zugewandt ist, aufweist und wobei. die zweite Grenzfläche der Oxidschicht eine Rauhigkeit besitzt, die kleiner ist als 1,0 nm.

Durch das Ausbilden der Spiegelschicht auf der zweiten Grenzfläche verringerter Rauhigkeit erhöht sich der Reflexionsgrad an der Grenzfläche zwischen Oxidschicht und Spiegelschicht, wobei vor allem die unter großen Einfallswinkeln auftreffenden Strahlungsanteile in einem größeren Ausmaß reflektiert werden.

Wird die Oxidschicht mit einer Schichtdicke von mehr als 5 nm vorgesehen, so ist gewährleistet, dass Unebenheiten der ersten Grenzfläche der Oxidschicht, die durch die Rauhigkeit der darunterliegenden obersten Halbleiterschicht bedingt sind, nivelliert werden und daher die Rauhigkeit der zweiten Grenzfläche der Oxidschicht nicht nachteilig beeinflussen.

Ist die p-dotierte Leuchtdiodenschicht näher an der Oxidschicht angeordnet als die n-dotierte Leuchtdiodenschicht, so befinden sich die Oxidschicht und die Spiegelschicht auf der p-Seite der Halbleiterleuchtdiode. Dort bringt das Anschließen der Oxidschicht zwar zunächst eine Erhöhung der Betriebspannung der Halbleiterleuchtdiode mit sich, die sich jedoch wie noch nachstehend beschrieben kompensieren lässt.

Gemäß einer Weiterbildung ist zwischen der p-dotierten Leuchtdiodenschicht und der Oxidschicht eine p-dotierte Halbleiterschicht angeordnet, die eine Dotierstoffkonzentration besitzt, die mindestens so groß ist wie die Dotierstoffkonzentration der p-dotierten Leuchtdiodenschicht. Die p-dotierte Halbleiterschicht schützt die p-dotierte Leuchtdiodenschicht vor Kristallgitterschäden beim Abscheiden der Oxidschicht.

Gemäß einer ersten Ausführungsform grenzt die erste Grenzfläche der Oxidschicht an die p-dotierte Halbleiterschicht an. Gemäß einer alternativen zweiten Ausführungsform ist vorgesehen sein, dass zwischen der p-dotierten Halbleiterschicht und der Oxidschicht eine n-dotierte Halbleiterschicht angeordnet ist und dass die Oxidschicht an die n-dotierte Halbleiterschicht angrenzt. Dadurch wird ein niederohmiger Anschluss der Oxidschicht an den Halbleiterschichtenstapel erreicht. Gemäß einer Weiterbildung ist zwischen der p-dotierten Halbleiterschicht und der n-dotierten Halbleiterschicht eine undotierte Halbleiterschicht vorgesehen. Diese bildet gemeinsam mit den beiden dotierten Halbleiterschichten einen Tunnelkontakt, wobei der Kontaktwiderstand des Tunnelkontakts durch das niederohmige Anschließen der Oxidschicht über die n-dotierte Halbleiterschicht mehr als kompensiert wird und die erforderliche Betriebspannung daher insgesamt verringert wird.

Vorzugsweise ist die Oxidschicht elektrisch leitfähig.

Geeignete Materialien für die Oxidschicht sind beispielsweise Zinkoxid, Indiumzinnoxid oder Indiumzinkoxid. Da die Spiegelschicht unmittelbar an die zweite Grenzfläche der Oxidschicht angrenzt, bildet die zweite Grenzfläche der Oxidschicht zugleich eine Spiegelfläche besonders geringer Rauhigkeit.

Die Spiegelschicht umfasst gemäß einer Ausführungsform mindestens eine metallische Spiegelschicht.

Geeignete Materialien für die metallische Spiegelschicht sind insbesondere Gold, Silber oder Aluminium, wobei sich Gold zur Reflexion im Infrarotbereich, Silber zur Reflexion im sichtbaren Wellenlängenbereich und Aluminium zur Reflexion im UV-Bereich eignet.

Gemäß einer weiteren Ausführungsform ist - alternativ oder zusätzlich zur metallischen Spiegelschicht - mindestens eine dielektrische Spiegelschicht vorgesehen. Insbesondere in Kombination mit der metallischen Spiegelschicht erhöht die dielektrische Spiegelschicht den Reflexionsgrad des Spiegels auf der Rückseite der Halbleiterleuchtdiode.

Geeignete Materialien für die dielektrische Spiegelschicht sind beispielsweise Glas, Siliziumoxid, Siliziumnitrid oder Siliziumoxinitrid.

Gemäß einer Weiterbildung ist vorgesehen, dass die dielektrische Spiegelschicht zwischen der Oxidschicht und der metallischen Spiegelschicht angeordnet ist und lokale Ausnehmungen aufweist, in denen die metallische Spiegelschicht bis an die zweite Grenzfläche der Oxidschicht heranreicht. Dadurch bildet die metallische Spiegelschicht Kontakte zur transparenten leitfähigen Oxidschicht, von denen ausgehend in der Oxidschicht eine laterale Stromaufweitung über die gesamte Grundfläche des Halbleiterschichtenstapels erfolgt.

Als Grundmaterial für die Leuchtdiodenschichten eignen sich etwa binäre, ternäre oder quaternäre III-V-Halbleitermaterialien, insbesondere solche, die zumindest eines der Elemente Aluminium, Gallium und Indium und zumindest eines der Elemente Stickstoff, Phosphor und Arsen enthalten. Beispiele hierfür sind Aluminiumnitrid, Aluminiumindiumnitrid, Galliumnitrid, Aluminiumgalliumnitrid, Indiumgalliumnitrid sowie Indiumgalliumarsenidphosphid.

Das Verfahren zum Herstellen der Halbleiterleuchtdiode umfasst
- das Ausbilden zumindest einer p-dotierten Leuchtdiodenschicht und einer n-dotierten Leuchtdiodenschicht,
- das Abscheiden eines transparenten leitfähigen Oxids, wodurch eine Oxidschicht gebildet wird, die eine erste Grenzfläche aufweist, die den Leuchtdiodenschichten zugewandt ist, wobei die Oxidschicht durch HF-unterstütztes DC-Sputtern abgeschieden wird und dabei eine zur ersten Grenzfläche entgegengesetzte zweite Grenzfläche der Oxidschicht erzeugt wird, die eine geringere Rauhigkeit besitzt als die erste Grenzfläche der Oxidschicht, und
- das Ausbilden mindestens einer Spiegelschicht oberhalb der zweiten Grenzfläche der Oxidschicht.
Dadurch, dass die Oxidschicht aus dem transparenten leitfähigen Oxid durch HF-unterstütztes DC-Sputtern abgeschieden wird, besitzt ihre zweite Grenzfläche eine Rauhigkeit, die kleiner ist als die Rauhigkeit ihrer ersten Grenzfläche und kleiner ist als 1,0 nm. Dies führt bei der fertigen Halbleiterleuchtdiode zu einer stärkeren Reflexion bzw. Spiegelwirkung an der Grenzfläche zwischen der Oxidschicht und der Spiegelschicht.

Wird die Oxidschicht mit einer Schichtdicke von mindestens 5 nm abgeschieden, so werden dadurch Unebenheiten der ersten Grenzfläche der Oxidschicht, die durch die Rauhigkeit der darunterliegenden obersten Halbleiterschicht bedingt sind, nivelliert und können die Rauhigkeit der zweiten Grenzfläche der Oxidschicht nicht nachteilig beeinflussen.

Gemäß einer Weiterbildung wird auf die p-dotierte Leuchtdiodenschicht eine p-dotierte Halbleiterschicht abgeschieden, deren Dotierstoffkonzentration mindestens so groß ist wie die Dotierstoffkonzentration der p-dotierten Leuchtdiodenschicht. Die p-dotierte Halbleiterschicht schützt die p-dotierte Leuchtdiodenschicht vor Kristallgitterschäden beim Aufsputtern der Oxidschicht.

Werden ferner über der p-dotierten Halbleiterschicht eine undotierte Halbleiterschicht sowie eine n-dotierte Halbleiterschicht abgeschieden und wird die Oxidschicht auf die n-dotierte Halbleiterschicht aufgesputtert, so entsteht ein niederohmiger Anschluss der Oxidschicht über die n-dotierte Halbleiterschicht; die p-dotierte, die undotierte und die n-dotierte Halbleiterschicht bilden dabei einen Tunnelkontakt, dessen Kontaktwiderstand durch den niederohmigen Anschluss der Oxidschicht an die n-dotierte Halbleiterschicht mehr als kompensiert wird.

Gemäß einer Weiterbildung umfasst das Ausbilden der Spiegelschicht das Abscheiden mindestens einer dielektrischen Spiegelschicht, das Ätzen von Ausnehmungen in die dielektrische Spiegelschicht und das Abscheiden mindestens einer metallischen Spiegelschicht auf die dielektrische Spiegelschicht; dadurch bildet die metallische Spiegelschicht in den Ausnehmungen der dielektrischen Spiegelschicht Kontakte zur Oxidschicht, von denen ausgehend in der Oxidschicht die laterale Stromaufweitung über die gesamte Grundfläche des Halbleiterschichtenstapels erfolgt.

Nachstehend werden einige Ausführungsbeispiele der Erfindung mit Bezug auf die Figuren beschrieben. Es zeigen:
Figur 1 ein erstes Ausführungsbeispiel einer Halbleiterleuchtdiode,
Figur 2 ein zweites Ausführungsbeispiel einer Halbleiterleuchtdiode,
Figur 3 ein drittes Ausführungsbeispiel einer Halbleiterleuchtdiode mit mehreren Spiegelschichten,
Figur 4 ein viertes Ausführungsbeispiel einer Halbleiterleuchtdiode mit mehreren Spiegelschichten und
Figur 5 eine vergrößerte schematische Detailansicht eines vorläufigen Halbleiterprodukts während der Herstellung einer Halbleiterleuchtdiode gemäß einer der Figuren 1 bis 4.

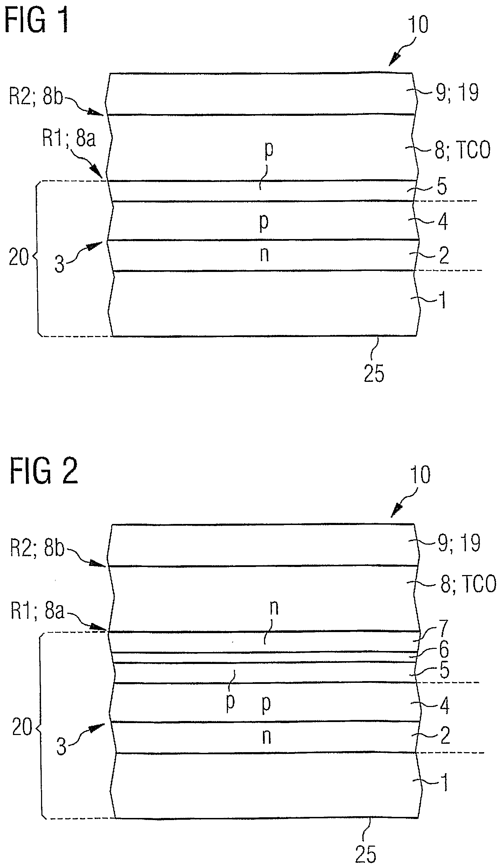

Figur 1 zeigt in Querschnittsansicht ein erstes Ausführungsbeispiel einer Halbleiterleuchtdiode 10, die einen Halbleiterschichtenstapel 20 aufweist. Die erzeugte elektromagnetische Strahlung, die im sichtbaren Bereich, im InfrarotBereich oder im UV-Bereich liegt, wird zwar zunächst in alle Richtungen emittiert, soll jedoch möglichst vollständig durch eine Strahlungsaustrittsfläche 25 einer Strahlungsaustrittsschicht 1 (unten in Figur 1) abgestrahlt werden, die auf derjenigen Seite des Halbleiterschichtenstapels angeordnet ist, die von der Oxidschicht und der Spiegelschicht abgewandt ist. Die Strahlungsaustrittsschicht 1 ist entweder eine Substratschicht, die zurückbleibt, nachdem sämtliche Schichten auf das Substrat aufgewachsen wurden und das Substrat nahezu vollständig rückgeätzt wurde (Dünnfilm-LED), oder eine Halbleiterschicht, die vor den eigentlichen Leuchtdiodenschichten auf das Substrat aufgewachsen wurde, wobei das Substrat später vollständig entfernt wurde.

Auf die Strahlungsaustrittsschicht 1 werden die weiteren Schichten wie folgt aufgewachsen: Zunächst werden eine n-dotierte Leuchtdiodenschicht 2 und eine p-dotierte Leuchtdiodenschicht 4 abgeschieden. Die entgegengesetzt zueinander dotierten Leuchtdiodenschichten 2, 4 bilden eine Leuchtdiodenschichtenfolge, wie in Figur 1 durch gestrichelte Linien hervorgehoben. An der Grenzfläche zwischen beiden Halbleiterschichten 2, 4 entsteht eine optisch aktive Zone 3, die bei ausreichender Vorspannung geeigneter Polung an den Leuchtdiodenschichten 2, 4 eine Emission elektromagnetischer Strahlung bewirkt. Die n-dotierte Leuchtdiodenschicht 2 ist hier mit Silizium und die p-dotierte Leuchtdiodenschicht 4 mit Magnesium dotiert, wobei das Grundmaterial der Leuchtdiodenschichten 2, 4 jeweils ein III-V-Halbleitermaterial ist. Die Strahlungsaustrittsschicht 1 dient zum Schutz und zur elektrischen Isolierung der unteren, n-dotierten Leuchtdiodenschicht 2.

Auf derjenigen Seite der Leuchtdiodenschichtenfolge, auf der die p-dotierte Leuchtdiodenschicht 4 angeordnet ist (d. h. in Figur 1 oben), wird eine Oxidschicht 8 aus einem transparenten leitfähigen Oxid abgeschieden. Insbesondere enthält die Oxidschicht 8 ein transparentes elektrisch leitfähiges Oxid.

Die Oxidschicht dient zur Stromaufweitung in lateraler Richtung parallel zu den Schichtgrenzen sowie zur Vermeidung unerwünschter Migration zwischen der Spiegelschicht und dem Halbleiterschichtenstapel. Figur 1 zeigt ein Ausführungsbeispiel, bei dem die Oxidschicht 8 nicht unmittelbar auf die p-dotierte Leuchtdiodenschicht 4 abgeschieden wird, sondern (zum Schutz der p-dotierten Leuchtdiodenschicht 4) zuerst eine p-dotierte Halbleiterschicht 5 abgeschieden wird, deren Dotierstoffkonzentration mindestens so groß ist wie diejenige der p-dotierten Leuchtdiodenschicht 4.

Auf die p-dotierte Halbleiterschicht 5 wird dann die Oxidschicht 8 aus einem transparenten leitfähigen Oxid (TCO; transparent conductive oxide) abgeschieden. Dabei gibt die Rauhigkeit der Oberseite der p-dotierte Halbleiterschicht 5 die Rauhigkeit R1 der ersten Grenzfläche 8a der Oxidschicht 8 vor. Als erste Grenzfläche der Oxidschicht wird hier diejenige Grenzfläche bezeichnet, die dem Halbleiterschichtenstapel zugewandt ist (und insbesondere an die oberste, zuletzt abgeschiedene Halbleiterschicht des Schichtenstapels unmittelbar angrenzt).

Als transparentes leitfähiges Oxid eignet sich etwa Indiumzinnoxid, Indiumzinkoxid oder Zinkoxid. Im Falle von Zinkoxid kann die Leitfähigkeit durch eine Dotierung mit Aluminium oder Gallium erhöht werden. Ferner kann anstelle einer einzigen Oxidschicht auch eine Schichtenfolge mehrerer Oxidschichten vorgesehen sein.

Die Abscheidung der Oxidschicht erfolgt durch HF-unterstütztes DC-Sputtern; dadurch erhält sie eine obere, zweite Grenzfläche 8b, die eine besonders geringe Rauhigkeit R2 besitzt. Nach dem Aufsputtern der Oxidschicht 8 liegt ihre zweite Grenzfläche 8b zunächst frei; auf ihr wird gemäß Figur 1 schließlich die Spiegelschicht 9 (insbesondere eine metallische Spiegelschicht 19) abgeschieden.

Die Grenzflächen zwischen den jeweiligen Schichten des Halbleiterschichtenstapels sowie zwischen dem Halbleiterschichtenstapel, der Oxidschicht und der Spiegelschicht besitzen stets eine gewisse Rauhigkeit. Die Rauhigkeit wird meist als numerische Angabe (etwa in nm) mit dem Zusatz 'Rms' angegeben ('root means squared'; Wurzel aus der mittleren quadratischen Abweichung von der idealisierten Grenzflächenebene, d.h. Standardabweichung der Höhenschwankung der Grenzfläche oder Oberfläche). Die Mittelung erfolgt dabei über einen Flächenbereich der jeweiligen Oberfläche bzw. Grenzfläche. Die Rauhigkeit von Grenzflächen innerhalb der Schichtenfolge für die Halbleiterleuchtdiode 10 liegt herkömmlich günstigstenfalls zwischen 1,5 und 5 nm, kann jedoch auch wesentlich größer sein und mehr als 20 nm betragen. Zur Rauhigkeit tragen insbesondere Abweichungen vom idealen Kristallgitter bei, beispielsweise lokal variierende Wachstumsbedingungen oder Gitterverzerrungen, auch als Folge von Dotierstoffen.

Bei der Herstellung einer Halbleiterleuchtdiode werden herkömmlich die Materialien und Materialkombinationen der jeweiligen Schichten (samt Dotierstoffen) optimiert und aufeinander abgestimmt. Ferner werden Schichtdicken und Brechungsindizes der Schichten optimiert, um eine konstruktive Interferenz der an den Grenzflächen reflektierten elektromagnetischen Strahlung und damit eine große Helligkeit der Leuchtdiode zu erzielen. Der Einfluss rauhigkeitsbedingter Höhenschwankungen der Schichtgrenzen, die um zwei bis drei Größenordnungen (entsprechend einem Faktor von 100 bis 1000) kleiner sind als die Wellenlänge der zu reflektierenden Strahlung, wird hingegen meist vernachlässigt.

Herkömmlich besitzt die zweite Grenzfläche der Oxidschicht, welche dem Halbleiterschichtenstapel abgewandt, d.h. der Spiegelschicht zugewandt ist, eine noch größere Rauhigkeit als die erste Grenzfläche der Oxidschicht, da das transparente leitfähige Oxid in der Regel nicht einkristallin, sondern polykristallin oder amorph aufwächst.

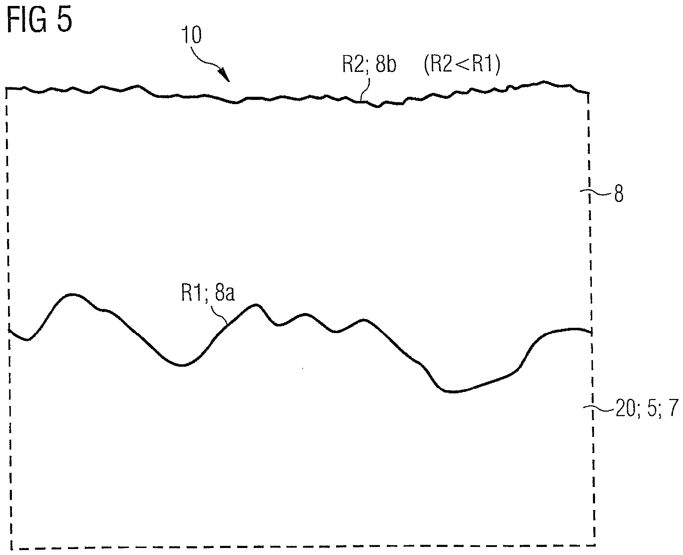

Das Abscheiden der Oxidschicht 8 durch einen HF-unterstützten DC-Sputterprozess wie hier vorgeschlagen bewirkt hingegen eine besonders geringe Rauhigkeit R2 der zweiten Grenzfläche 8b der Oxidschicht und erhöht so das Reflexionsvermögen der darauf abzuscheidenden Spiegelschicht. Auf den HF-unterstützten DC-Sputterprozess wird noch mit Bezug auf Figur 5 eingegangen.

Die Spiegelschicht 9 wird auf die (nach Durchführung des Sputterprozesses freiliegende) zweite Grenzfläche 8b der Oxidschicht 8 abgeschieden. Die Abscheidung der Spiegelschicht 9 erfolgt durch ein PVD- (physical vapour deposition) oder ein CVD-Verfahren (chemical vapour deposition), insbesondere ein PECVD-Verfahren (plasma enhanced chemical vapour deposition), durch ein MBE-Verfahren (molecular beam epitaxy), ein IBE-Verfahren (ion beam etching) oder durch thermisches Verdampfen. Die Spiegelschicht 9 ist bei diesem Ausführungsbeispiel eine metallische Spiegelschicht 19, die aus Gold, Silber oder Aluminium oder einer Legierung, die mindestens eines dieser Metalle enthält, besteht. Die metallische Spiegelschicht 19 kann auch mehrere Schichten aus jeweils einem Metall oder einer Metalllegierung umfassen.

Die Materialien und Schichtdicken der Oxidschicht 8 und der Spiegelschicht 9 sind so aufeinander abgestimmt, dass derjenige Anteil der von der optisch aktiven Zone 3 emittierten elektromagnetischen Strahlung, der in Richtung der Oxidschicht und der Spiegelschicht emittiert wird, an der zweiten Grenzfläche 8b der Oxidschicht 8 möglichst vollständig reflektiert wird. Der Einfallswinkel der zu reflektierenden Strahlung unterliegt einer statistischen Verteilung und kann grundsätzlich jeden Wert zwischen 0 Grad und 90 Grad relativ zur Flächennormalen der reflektierenden Grenzfläche der Spiegelschicht annehmen. Die geringe Rauhigkeit der zweiten Grenzfläche 8b der Oxidschicht 8 hat zur Folge, dass auch bei großen Einfallswinkeln relativ zur Flächennormalen der zweiten Grenzfläche 8b insgesamt ein größerer Anteil der auftreffenden elektromagnetischen Strahlung reflektiert wird. Dadurch wird die Intensität der durch die Halbleiterleuchtdiode abgestrahlten elektromagnetischen Strahlung erhöht.

Figur 2 zeigt ein zweites Ausführungsbeispiel einer Halbleiterleuchtdiode, bei dem zusätzlich zu den in Figur 1 dargestellten Schichten noch eine undotierte Halbleiterschicht 6 sowie eine n-dotierte Halbleiterschicht 7 vorgesehen sind, die zwischen der p-dotierten Halbleiterschicht 5 und der Oxidschicht 8 angeordnet sind. Die n-dotierte Halbleiterschicht 7 erleichtert das Anschließen der Oxidschicht 8 aus dem transparenten leitfähigen Oxid an den Halbleiterschichtenstapel 20. Die undotierte Halbleiterschicht 6 ist zwischen der p-dotierten Halbleiterschicht 5 und der n-dotierten Halbleiterschicht 7 angeordnet. Die Folge der Halbleiterschichten 5, 6 und 7 bildet einen Tunnelkontakt zur eigentlichen Leuchtdiodenschichtenfolge aus den Leuchtdiodenschichten 4 und 2. Eine geringfügige Erhöhung der Betriebsspannung durch den Tunnelkontakt wird durch den niederohmigen Anschluss der Oxidschicht 8 über die n-dotierte Halbleiterschicht 7 mehr als kompensiert.

Für die Schichten 5, 6 und 7 eignen sich dieselben Grundmaterialien wie für die Leuchtdiodenschichten 2, 4. Die Schichtdicke der dotierten Halbleiterschichten 5, 7 ist bei diesem Ausführungsbeispiel kleiner als 30 nm; sie liegt beispielsweise zwischen 3 und 20 nm. Ferner ist die Schichtdicke der undotierten Halbleiterschicht 6 bei diesem Ausführungsbeispiel kleiner als 20 nm; sie liegt beispielsweise zwischen 1 und 10 nm. Im übrigen gelten für Figur 2 dieselben Ausführungen wie für Figur 1.

Die in den Figuren 1 und 2 dargestellten Schichten des Halbleiterschichtenstapels 20 werden beispielsweise durch ein chemisches Gasphasenabscheidungsverfahren (CVD; chemical vapour deposition) abgeschieden, bevor auf den Halbleiterschichtenstapel 20 die Oxidschicht 8 und darauf die Spiegelschicht 9 abgeschieden wird. Auf der Unterseite des Halbleiterschichtenstapels 20 wird das Substrat nachträglich gedünnt oder vollständig entfernt, sodass die Strahlungsaustrittsschicht 1 freiliegt.

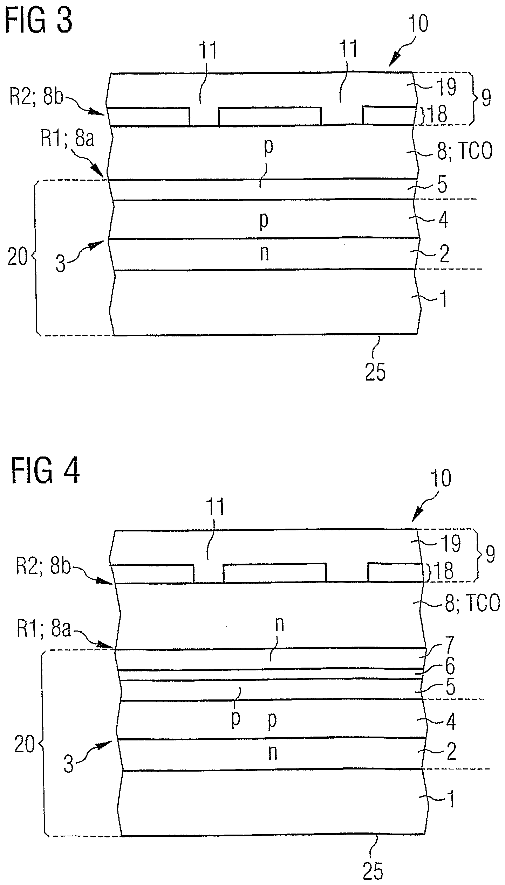

Während die Figuren 1 und 2 Ausführungsbeispiele zeigen, bei denen die Oxidschicht 8 unmittelbar an die Unterseite einer metallischen Spiegelschicht 19 angrenzt, zeigen die Figuren 3 und 4 Ausführungsbeispiele mit einer zusätzlichen dielektrischen Spiegelschicht 18 zwischen der Oxidschicht 8 und der metallischen Spiegelschicht 19. In Figur 3 besitzt der Halbleiterschichtenstapel 20 denselben Aufbau wie in Figur 1; in Figur 4 besitzt er denselben Aufbau wie in Figur 2. Die Erläuterungen zu Figur 1 bzw. 2 gelten daher ebenso für Figur 3 bzw. 4.

Gemäß Figur 3 bzw. 4 wird auf die jeweils oberste Halbleiterschicht 5 bzw. 7 die Oxidschicht 8 durch HF-unterstütztes DC-Sputtern abgeschieden. Auf deren zweite Grenzfläche 8b wird dann zunächst eine dielektrische Spiegelschicht 18 (beispielsweise aus Siliziumoxid) abgeschieden. In die dielektrische Spiegelschicht 18 werden dann Ausnehmungen 11 geätzt und es wird eine metallische Spiegelschicht 19 auf die dielektrische Spiegelschicht 18 abgeschieden. In den Ausnehmungen der dielektrischen Spiegelschicht 18 reicht das Material der metallischen Spiegelschicht 19 bis an die zweite Grenzfläche 8b der Oxidschicht 8 heran und bildet dort somit Knüpfelkontakte zur Oxidschicht 8. Von den Knüpfelkontakten ausgehend erfolgt dann in der transparenten leitfähigen Oxidschicht 8 die laterale Stromaufweitung über die gesamte Grundfläche des Halbleiterschichtenstapels 20.

Die Spiegelschicht 9 umfasst bei diesem Ausführungsbeispiel sowohl eine dielektrische Spiegelschicht 18 als auch eine metallische Spiegelschicht 19. Da die Spiegelschichten 9; 18, 19 nach der Oxidschicht 8 abgeschieden werden, verringert sich durch die geringe Rauhigkeit R2 der zweiten Grenzfläche 8b der Oxidschicht 8 auch die Rauhigkeit der Grenzfläche zwischen den Spiegelschichten 18 und 19. Dadurch wird der Reflexionsgrad des Spiegelschichtenstapels weiter erhöht, denn durch die geringe Rauhigkeit der zweiten Grenzfläche der Oxidschicht verringert sich in gewissem Ausmaß auch die Rauhigkeit der Grenzflächen nachfolgender Spiegelschichten. Im Übrigen gelten für Figur 3 und 4 dieselben Ausführungen wie für Figur 1 und 2.

Bei den oben genannten Ausführungsbeispielen sind die folgenden Dotierstoffkonzentrationen vorgesehen: Die n-dotierte Leuchtdiodenschicht 2 besitzt eine Dotierstoffkonzentration kleiner als 1 x 10²⁰/cm³, insbesondere unterhalb von 1 x 10¹⁹/cm³. Die p-dotierte Leuchtdiodenschicht 4 besitzt eine Dotierstoffkonzentration kleiner als 2 x 10²⁰/cm³. Die Dotierstoffkonzentration der p-dotierten Halbleiterschicht 5 ist mindestens so groß wie diejenige der p-dotierten Leuchtdiodenschicht 4 und liegt oberhalb von 2 x 10²⁰/cm³. Die Dotierstoffkonzentration der n-dotierten Halbleiterschicht 7 ist größer als diejenige der n-dotierten Leuchtdiodenschicht 2 und liegt oberhalb von 2 x 10²⁰/cm³. Somit ist jede der beiden Halbleiterschichten 5, 7 stärker dotiert als die jeweilige Leuchtdiodenschicht 4, 2 desselben Dotierstofftyps. Die p-dotierten Schichten sind mit Magnesium und die n-dotierten Schichten mit Silizium dotiert.

Alternativ kann die Dotierstoffkonzentration der n-dotierten Halbleiterschicht 7 auch kleiner sein als die Dotierstoffkonzentration der n-dotierten Leuchtdiodenschicht 2.

Figur 5 zeigt eine vergrößerte schematische Detailansicht eines vorläufigen Halbleiterprodukts zur Herstellung der Halbleiterleuchtdiode gemäß einer der Figuren 1 bis 4, und zwar nach dem Aufsputtern der Oxidschicht 8. Dargestellt ist ein oberer Teilbereich der obersten Schicht des Halbleiterschichtenstapels 20 sowie der darauf aufgesputterten Oxidschicht aus dem transparenten leitfähigen Oxid. Die oberste Halbleiterschicht ist entweder die p-dotierte Halbleiterschicht 5 aus Figur 1 bzw. 3 oder die n-dotierte Halbleiterschicht 7 aus Figur 2 bzw. 4.

Wenn auf die Oberseite der obersten Halbleiterschicht 5 bzw. 7 die Oxidschicht 8 abgeschieden wird, gibt die Rauhigkeit der obersten Halbleiterschicht die Rauhigkeit R1 der unteren, ersten Grenzfläche 8a der Oxidschicht 8 vor; sie liegt typischerweise oberhalb von 1,5 nm Rms, kann jedoch auch wesentlich größere Werte annehmen - je nach Abscheidungsverfahren für die oberste Halbleiterschicht, deren Grundmaterial und deren Dotierstoffkonzentration. Im Falle einer p-dotierten Halbleiterschicht 5 (Figur 1 bzw. 3) aus Galliumnitrid beträgt die Rauhigkeit ihrer Oberseite zwischen 1,2 bis 1,8 nm.

Durch das HF-unterstützte DC-Sputter-Verfahren zum Abscheiden der Oxidschicht 8 aus dem transparenten leitfähigen Oxid wird erreicht, dass die Rauhigkeit R2 ihrer zweiten Grenzfläche 8b wie in Figur 5 dargestellt kleiner ist als die Rauhigkeit R1 der ersten Grenzfläche 8a, insbesondere kleiner als 1,0 nm oder gar 0,5 nm.

Die Oxidschicht 8 wird bei den hier beschriebenen Ausführungsbeispielen mit einer Schichtdicke von zwischen 1 und 50 nm aufgesputtert, wobei die Schichtdicke auch größer gewählt werden kann. Wird die Oxidschicht mit einer Mindestschichtdicke von beispielsweise 5 nm abgeschieden, so werden Unebenheiten, die von der darunterliegenden Halbleiterschicht 5 bzw. 7 herrühren, während des Aufsputterns der Oxidschicht nivelliert. Dadurch ist gewährleistet, dass die Rauhigkeit R2 der zweiten Grenzfläche 8b der Oxidschicht 8 nur noch durch das HF-unterstützte DC-Sputter-Verfahren, jedoch nicht durch Höhenschwankungen tieferliegender Halbleiterschichten beeinflusst wird.

Die Spiegelschichten, die auf der (durch das HF-unterstützte DC-Sputtern abgeschiedenen) Oxidschicht angeordnet sind, weisen äußerst glatte Reflexionsflächen auf. Zudem wird die vor dem Aufsputtern der Oxidschicht 8 freiliegende oberste Halbleiterschicht des Halbleiterschichtenstapels durch das HF-unterstützte DC-Sputter-Verfahren kaum geschädigt.

Das HF-unterstützte DC-Sputter-Verfahren, das als solches bekannt ist, wird hier zum Abscheiden der Oxidschicht 8 aus dem transparenten leitfähigen Oxid auf die oberste Schicht des Halbleiterschichtenstapels 20 für die Leuchtdiode eingesetzt. Bei dem HF-unterstützten DC-Sputter-Verfahren wird einer elektrischen Gleichspannung eine hochfrequente Wechselspannung überlagert. Die zum Sputtern zugeführte elektrische Leistung umfasst somit einen DC-Anteil (direct current) sowie einen Hochfrequenz-Anteil (HF; high frequency). Die Frequenz des hochfrequenten Leistungsanteils beträgt beispielsweise 13,56 MHz. Beim Sputtern wird die kombinierte DC/HF-Leistung beispielsweise einer in einer Sputterkammer angeordneten Elektrode zugeführt.

Die zweite Grenzfläche 8b der durch das HF-unterstützte DC-Sputter-Verfahren abgeschiedenen Oxidschicht 8 und die Grenzflächen der weiteren, auf die zweite Grenzfläche 8b abgeschiedenen Spiegelschichten 18, 19 reflektieren aufgrund der verringerten Rauhigkeit einen höheren Anteil der auf sie auftreffenden elektromagnetischen Strahlung. Dies gilt insbesondere für diejenigen Strahlungsanteile, die unter größeren Einfallswinkeln relativ zur Flächennormalen auf diese Grenzflächen auftreffen.

Durch den erhöhten Reflexionsgrad strahlt die Halbleiterleuchtdiode 10 an ihrer Strahlungsaustrittsfläche 25 insgesamt eine größere Intensität elektromagnetischer Strahlung ab.

## Patentansprüche

1. Halbleiterleuchtdiode (10) mit:
- zumindest einer p-dotierten Leuchtdiodenschicht (4), einer n-dotierten Leuchtdiodenschicht (2) sowie einer optisch aktiven Zone (3) zwischen der p-dotierten Leuchtdiodenschicht (4) und der n-dotierten Leuchtdiodenschicht (2),
- einer Oxidschicht (8) aus einem transparenten leitfähigen Oxid und
- mindestens einer Spiegelschicht (9),
wobei die Oxidschicht (8) zwischen den Leuchtdiodenschichten (2, 4) und der mindestens einen Spiegelschicht (9) angeordnet ist und eine erste Grenzfläche (8a), die den Leuchtdiodenschichten (2, 4) zugewandt ist, und eine zweite Grenzfläche (8b), die der mindestens einen Spiegelschicht (9) zugewandt ist, aufweist und
wobei die Spiegelschicht (9) an die zweite Grenzfläche (8b) der Oxidschicht (8) angrenzt,
**dadurch gekennzeichnet, dass**
die zweite Grenzfläche (8b) der Oxidschicht (8) eine Rauhigkeit (R2) besitzt, die kleiner ist als 1,0 nm.

2. Halbleiterleuchtdiode nach Anspruch 1,
**dadurch gekennzeichnet, dass**
die Oxidschicht (8) eine Schichtdicke größer als 5 nm besitzt.

3. Halbleiterleuchtdiode nach Anspruch 1 oder 2,
**dadurch gekennzeichnet, dass**
die p-dotierte Leuchtdiodenschicht (4) näher an der Oxidschicht (8) angeordnet ist als die n-dotierte Leuchtdiodenschicht (2).

4. Halbleiterleuchtdiode nach einem der Ansprüche 1 bis 3,
**dadurch gekennzeichnet, dass**
zwischen der p-dotierten Leuchtdiodenschicht (4) und der Oxidschicht (8) eine p-dotierte Halbleiterschicht (5) angeordnet ist, die eine Dotierstoffkonzentration besitzt, die mindestens so groß ist wie die Dotierstoffkonzentration der p-dotierten Leuchtdiodenschicht (4).

5. Halbleiterleuchtdiode nach Anspruch 4,
**dadurch gekennzeichnet, dass**
die Oxidschicht (8) mit ihrer ersten Grenzfläche (8a) an die p-dotierte Halbleiterschicht (5) angrenzt.

6. Halbleiterleuchtdiode nach Anspruch 4,
**dadurch gekennzeichnet, dass**
zwischen der p-dotierten Halbleiterschicht (5) und der Oxidschicht (8) eine n-dotierte Halbleiterschicht (7) angeordnet ist und dass die erste Grenzfläche (8a) der Oxidschicht (8) an die n-dotierte Halbleiterschicht (7) angrenzt.

7. Halbleiterleuchtdiode nach Anspruch 6,
**dadurch gekennzeichnet, dass**
zwischen der p-dotierten Halbleiterschicht (5) und der n-dotierten Halbleiterschicht (7) eine undotierte Halbleiterschicht (6) angeordnet ist.

8. Halbleiterleuchtdiode nach einem der Ansprüche 1 bis 7,
**dadurch gekennzeichnet, dass**
das transparente leitfähige Oxid der Oxidschicht (8) zumindest eines der Materialien Zinkoxid, Indiumzinnoxid und Indiumzinkoxid enthält.

9. Halbleiterleuchtdiode nach einem der Ansprüche 1 bis 8,
**dadurch gekennzeichnet, dass**
die Spiegelschicht (9) mindestens eine metallische Spiegelschicht (19) umfasst.

10. Halbleiterleuchtdiode nach einem der Ansprüche 1 bis 9,
**dadurch gekennzeichnet, dass**
die Spiegelschicht (9) mindestens eine dielektrische Spiegelschicht (18) umfasst.

11. Halbleiterleuchtdiode nach Anspruch 10,
**dadurch gekennzeichnet, dass**
die dielektrische Spiegelschicht (18) zwischen der Oxidschicht (8) und der metallischen Spiegelschicht (19) angeordnet ist und lokale Ausnehmungen (11) aufweist, in denen die metallische Spiegelschicht (19) bis an die zweite Grenzfläche (8b) der Oxidschicht (8) heranreicht.

12. Verfahren zum Herstellen einer Halbleiterleuchtdiode (10), wobei das Verfahren folgendes umfasst:
- Ausbilden zumindest einer p-dotierten Leuchtdiodenschicht (4) und einer n-dotierten Leuchtdiodenschicht (2),
- Abscheiden eines transparenten leitfähigen Oxids, wodurch eine Oxidschicht (8) gebildet wird, die eine erste Grenzfläche (8a) aufweist, die den Leuchtdiodenschichten (2, 4) zugewandt ist, wobei die Oxidschicht (8) durch HF-unterstütztes DC-Sputtern abgeschieden wird und dabei eine zur ersten Grenzfläche (8a) entgegengesetzte zweite Grenzfläche (8b) der Oxidschicht (8) erzeugt wird, wobei die zweite Grenzfläche (8b) der Oxidschicht (8) eine Rauhigkeit (R2) besitzt, die kleiner ist als 1,0 nm und eine geringere Rauhigkeit besitzt als die erste Grenzfläche (8a) der Oxidschicht (8), und
- Ausbilden mindestens einer Spiegelschicht (9) oberhalb der zweiten Grenzfläche (8b) der Oxidschicht (8), wobei die Spiegelschicht (9) an die zweite Grenzfläche (8b) der Oxidschicht (8) angrenzt.

13. Verfahren nach Anspruch 12,
**dadurch gekennzeichnet, dass**
das Ausbilden der mindestens einen Spiegelschicht (9) das Abscheiden mindestens einer dielektrischen Spiegelschicht (18), das Ätzen von Ausnehmungen in die dielektrische Spiegelschicht (18) und das Abscheiden mindestens einer metallischen Spiegelschicht (19) auf die dielektrische Spiegelschicht (18) umfasst.

## Claims

1. Semiconductor light-emitting diode (10) having:
- at least one p-doped light-emitting diode layer (4), an n-doped light-emitting diode layer (2) and an optically active zone (3) between the p-doped light-emitting diode layer (4) and the n-doped light-emitting diode layer (2),
- an oxide layer (8) of a transparent conductive oxide, and
- at least one mirror layer (9),
wherein the oxide layer (8) is disposed between the light-emitting diode layers (2, 4) and the at least one mirror layer (9), and comprises a first boundary surface (8a) which faces the light-emitting diode layers (2, 4) and a second boundary surface (8b) which faces the at least one mirror layer (9),
wherein the mirror layer (9) adjoins the second boundary surface (8b) of the oxide layer (8),
**characterised in that**
the second boundary surface (8b) of the oxide layer (8) has a roughness (R2), which is smaller than 0.1 nm.

2. Semiconductor light-emitting diode according to claim 1,
**characterised in that**
the oxide layer (8) has a layer thickness greater than 5 nm.

3. Semiconductor light-emitting diode according to claim 1 or 2,
**characterised in that**
the p-doped light-emitting diode layer (4) is disposed closer to the oxide layer (8) than the n-doped light-emitting diode layer (2).

4. Semiconductor light-emitting diode according to one of claims 1 to 3,
**characterised in that**
a p-doped semiconductor layer (5) is disposed between the p-doped light-emitting diode layer (4) and the oxide layer (8), wherein the p-doped semiconductor layer (5) has a dopant concentration which is at least as large as the dopant concentration of the p-doped light-emitting diode layer (4).

5. Semiconductor light-emitting diode according to claim 4,
**characterised in that**
the oxide layer (8) adjoins the p-doped semiconductor layer (5) with its first boundary surface (8a).

6. Semiconductor light-emitting diode according to claim 4,
**characterised in that**
an n-doped semiconductor layer (7) is disposed between the p-doped semiconductor layer (5) and the oxide layer (8), and **in that** the first boundary surface (8a) of the oxide layer (8) adjoins the n-doped semiconductor layer (7).

7. Semiconductor light-emitting diode according to claim 6,
**characterised in that**
a non-doped semiconductor layer (6) is disposed between the p-doped semiconductor layer (5) and the n-doped semiconductor layer (7).

8. Semiconductor light-emitting diode according to one of claims 1 to 7,
**characterised in that**
the transparent conductive oxide of the oxide layer (8) contains at least one of the materials zinc oxide, indium tin oxide and indium zinc oxide.

9. Semiconductor light-emitting diode according to one of claims 1 to 8,
**characterised in that**
the mirror layer (9) comprises at least one metallic mirror layer (19).

10. Semiconductor light-emitting diode according to one of claims 1 to 9,
**characterised in that**
the mirror layer (9) comprises at least one dielectric mirror layer (18).

11. Semiconductor light-emitting diode according to one of claims 1 to 9,
**characterised in that**
the dielectric mirror layer (18) is disposed between the oxide layer (8) and the metallic mirror layer (19) and comprises local recesses (11) in which the metallic mirror layer (19) extends as far as to the second boundary surface (8b) of the oxide layer (8).

12. Method for producing a semiconductor light-emitting diode (10), wherein the method includes the following:
- forming at least one p-doped light-emitting diode layer (4) and an n-doped light-emitting diode layer (2),
- depositing a transparent conductive oxide, whereby an oxide layer (8) is formed which comprises a first boundary surface (8a) which faces the light-emitting diode layers (2, 4), wherein the oxide layer (8) is deposited by means of HF-assisted DC sputtering and in doing so a second boundary surface (8b) of the oxide layer (8) opposing the first boundary surface (8a) is produced, wherein the second boundary surface (8b) of the oxide layer (8) has a roughness (R2), which is smaller than 0.1 nm, and has less roughness than the first boundary surface (8a) of the oxide layer (8), and
- forming at least one mirror layer (9) above the second boundary surface (8b) of the oxide layer (8), wherein the mirror layer (9) adjoins the second boundary surface (8b) of the oxide layer (8).

13. Method according to claim 12,
**characterised in that**
the forming of the at least one mirror layer (9) comprises the deposition of at least one dielectric mirror layer (18), the etching of recesses into the dielectric mirror layer (18) and the deposition of at least one metallic mirror layer (19) onto the dielectric mirror layer (18).

## Revendications

1. Diode électroluminescente à semi-conducteur (10), ayant:
- d'au moins une couche de diode électroluminescente dopée p (4), d'une couche de diode électroluminescente dopée n (2) ainsi que d'une zone active optique (3) entre la couche de diode électroluminescente dopée p (4) et la couche de diode électroluminescente dopée n (2),
- d'une couche d'oxyde (8) en oxyde conducteur transparent, et
- d'au moins une couche miroir (9),
la couche d'oxyde (8) étant disposée entre les couches de diode électroluminescente (2, 4) et l'au moins une couche miroir (9), et présentant une première interface (8a) tournée vers les couches de diode électroluminescente (2, 4), et une deuxième interface (8b) tournée vers l'au moins une couche miroir (9), et
la couche miroir (9) étant adjacente à la deuxième interface (8b) de la couche d'oxyde (8),
**caractérisée en ce que**
la deuxième interface (8b) de la couche d'oxyde (8) possède une rugosité (R2) inférieure à 1,0 nm.

2. Diode électroluminescente à semi-conducteur selon la revendication 1,
**caractérisée en ce que**
la couche d'oxyde (8) possède une épaisseur de couche supérieure à 5 nm.

3. Diode électroluminescente à semi-conducteur selon la revendication 1 ou 2,
**caractérisée en ce que**
la couche de diode électroluminescente dopée p (4) est disposée plus proche de la couche d'oxyde (8) que ne l'est la couche de diode électroluminescente dopée n (2).

4. Diode électroluminescente à semi-conducteur selon l'une quelconque des revendications 1 à 3,
**caractérisée en ce qu'**
est disposée entre la couche de diode électroluminescente dopée p (4) et la couche d'oxyde (8) une couche de semi-conducteur dopé p (5) qui possède une concentration en dopant qui est au moins aussi élevée que la concentration en dopant de la couche de diode électroluminescente dopée p (4).

5. Diode électroluminescente à semi-conducteur selon la revendication 4,
**caractérisée en ce que**
la couche d'oxyde (8) est, par sa première interface (8a), adjacente à la couche de semi-conducteur dopé p (5).

6. Diode électroluminescente à semi-conducteur selon la revendication 4,
**caractérisée en ce qu'**
est disposée entre la couche de semi-conducteur dopé p (5) et la couche d'oxyde (8) une couche de semi-conducteur dopé n (7), et que la première interface (8a) de la couche d'oxyde (8) est adjacente à la couche de semi-conducteur dopé n.

7. Diode électroluminescente à semi-conducteur selon la revendication 6,
**caractérisée en ce qu'**
une couche de semi-conducteur non dopé (6) est disposée entre la couche de semi-conducteur dopé p (5) et la couche de semi-conducteur dopé n (7).

8. Diode électroluminescente à semi-conducteur selon l'une quelconque des revendications 1 à 7,
**caractérisée en ce que**
l'oxyde conducteur transparent de la couche d'oxyde (8) contient au moins une des matières oxyde de zinc, oxyde d'étain d'indium et oxyde de zinc d'indium.

9. Diode électroluminescente à semi-conducteur selon l'une quelconque des revendications 1 à 8,
**caractérisée en ce que**
la couche miroir (9) comprend au moins une couche miroir métallique (19).

10. Diode électroluminescente à semi-conducteur selon l'une quelconque des revendications 1 à 9,
**caractérisée en ce que**
la couche miroir (9) comprend au moins une couche miroir diélectrique (18).

11. Diode électroluminescente à semi-conducteur selon la revendication 10,
**caractérisée en ce que**
la couche miroir diélectrique (18) est disposée entre la couche d'oxyde (8) et la couche miroir métallique (19) et qu'elle présente des entailles locales (11) dans lesquelles la couche miroir métallique (19) va jusqu'à la deuxième interface (8b) de la couche d'oxyde (8).

12. Procédé de fabrication d'une diode électroluminescente à semi-conducteur (10), le procédé comprenant comme suit :
- formation d'une couche de diode électroluminescente dopée p (4) et d'une couche de diode électroluminescente dopée n (2),
- dépôt d'un oxyde conducteur transparent permettant de constituer une couche d'oxyde (8) qui présente une première interface (8a) tournée vers les couches de diode électroluminescente (2, 4), la couche d'oxyde (8) étant déposée par pulvérisation cathodique DC soutenue par pulvérisation RF et générant alors une deuxième interface (8b) de la couche d'oxyde (8) opposée à la première interface (8a), la deuxième interface (8b) de la couche d'oxyde (8) possédant une rugosité (R2) inférieure à 1,0 nm et une rugosité inférieure à celle de la première interface (8a) de la couche d'oxyde (8), et
- formation d'au moins une couche miroir (9) au-dessus de la deuxième interface (8b) de la couche d'oxyde (8), la couche miroir (9) étant adjacente à la deuxième interface (8b) de la couche d'oxyde (8).

13. Procédé selon la revendication 12,
**caractérisé en ce que**
la formation de l'au moins une couche miroir (9) comprend le dépôt d'au moins une couche miroir diélectrique (18), la gravure d'entailles dans la couche miroir diélectrique (18) et le dépôt d'au moins une couche miroir métallique (19) sur la couche miroir diélectrique (18).
